# FASCICULE DE BREVET EUROPEEN

(11) **EP 4 387 079 B1**
(45) Date de publication et mention de la délivrance du brevet: **02.09.2026**
(21) Numéro de dépôt: 23215342.9
(22) Date de dépôt: 08.12.2023
(51) Int. Cl.: H02P 3/22, H02P 29/024, H02P 29/032

(54) **SYSTÈME DE COMMANDE D'UN CONVERTISSEUR DE TENSION**
STEUERUNGSSYSTEM FÜR EINEN SPANNUNGSWANDLER
SYSTEM FOR CONTROLLING A VOLTAGE CONVERTER

(30) Priorité: 16.12.2022 FR 2213531
(43) Date de publication de la demande: 19.06.2024
(73) Titulaire: Valeo Electrification, 95800 Cergy (FR)
(72) Inventeur: LAHBIL, Hicham, 94046 CRETEIL CEDEX (FR); FAVEROLLE, Pierre, 94046 CRETEIL CEDEX (FR)
(74) Mandataire: Valeo Powertrain Systems

(56) Documents cités:
- EP-A1- 3 413 153
- WO-A1-2020/124037
- WO-A1-2022/003011
- CN-A- 111 211 540
- US-A1- 2005 209 823
- US-A1- 2022 069 758
- LEE-ING TONG ET AL: "Using a Neural Network-Based Approach to Predict the Wafer Yield in Integrated Circuit Manufacturing", IEEE TRANSACTIONS ON COMPONENTS, PACKAGING AND MANUFACTURINGTECHNOLOGY. PART C: MANUFACTURING. IEEE SERVICE CENTER, PISCATAWAY, NJ., US, vol. 20, no. 4, 1 October 1997 (1997-10-01), XP011019917, ISSN: 1083-4400

## Description

### DOMAINE TECHNIQUE

La présente invention est relative aux systèmes électriques comprenant une machine électrique tournante pour véhicule automobile commandée par l'intermédiaire d'un convertisseur de tension. Elle concerne plus précisément un système de commande d'un convertisseur de tension et un système électrique comprenant une machine électrique tournante et un tel système de commande.

### ETAT DE LA TECHNIQUE

Dans le cas des équipements électriques tels que des convertisseurs de tension, il est connu de relier une source de tension, par exemple une source de tension continue à une machine électrique, par exemple une machine électrique tournante, par le biais de modules de puissance, dont le rôle est de commander en toute sécurité la nature et la quantité d'énergie électrique transférées de la source d'énergie vers la machine électrique.

Au sein d'un module de puissance, il est connu des interrupteurs commandables à semi-conducteurs, comme des interrupteurs à transistor tel qu'un transistor à effet de champ à grille métal-oxyde (de l'anglais « Metal Oxide Semiconductor Field Effect Transistor » également désigné par l'acronyme MOSFET) ou bien un transistor à effet de champ à grille métal-oxyde silicium (de l'anglais « Silicon Metal Oxide Semiconductor Field Effect Transistor » également désigné par l'acronyme Si MOSFET) ou bien un transistor à effet de champ à grille métal-oxyde au carbure de silicium (de l'anglais « Silicon Carbide Metal Oxide Semiconductor Field Effect Transistor » également désigné par l'acronyme SiC MOSFET) ou bien un transistor bipolaire à grille isolée (de l'anglais « Insulated Gate Bipolar Transistor » également désigné par l'acronyme IGBT) ou bien un transistor à effet de champ au nitrure de gallium (de l'anglais « Gallium Nitride Field Effect Transistor » également désigné par l'acronyme GaN FET.

Les interrupteurs permettent d'alimenter des phases d'un stator, soit dans un mode moteur à partir d'une batterie alimentant électriquement un réseau de bord du véhicule, soit dans un mode alternateur pour alimenter le réseau de bord et recharger une batterie du véhicule. Dans le cas d'une machine électronique comprenant trois phases au stator, le convertisseur de tension comprend trois interrupteurs côté bas reliés chacun à une des trois phases et à la masse et trois interrupteurs côté haut reliés chacun à une des trois phases et à une borne positive correspondant au réseau de bord du véhicule automobile.

Suite à une défaillance d'un équipement électrique du véhicule automobile relié au réseau de bord, il peut se produire une surtension sur le réseau de bord, c'est-à-dire l'apparition d'une tension sur le réseau de bord très supérieure à la tension nominale de ce réseau. Par exemple une telle surtension peut se produire dans le cas d'un défaut de fonctionnement d'un interrupteur du convertisseur de tension qui reste à l'état ouvert ou qui reste à l'état fermé alors que le système de commande le commande respectivement pour qu'il commute à l'état fermé ou à l'état ouvert.

Une telle surtension peut endommager ou réduire la fiabilité non seulement de la machine électrique tournante ou du convertisseur de tension et de son système de commande mais aussi d'éventuels équipements électriques connectés sur le réseau de bord, par exemple un convertisseur continu/continu, un autoradio etc...

Pour limiter ou arrêter la surtension, il est connu que le système de commande de la machine électrique comprenne un dispositif de détection de tension et de commander la fermeture et l'ouverture des autres interrupteurs en fonction du défaut identifié pour limiter ou arrêter la surtension. Par exemple, dans le cas d'un interrupteur de côté haut qui reste dans un état fermé, le détecteur va détecter un défaut d'état resté fermé pour cet interrupteur et transmettre l'information de détection de ce défaut à un module de commande du système de commande qui va commander la fermeture des deux autres interrupteurs haut et mettre ainsi la machine électrique tournante en sécurité par la mise de l'ensemble des phases du stator au même potentiel, c'est-à-dire que les phases sont en court-circuit. Le document US 2022/069758 A1 décrit par exemple un tel système de commande.

Ainsi, le système de commande protège le convertisseur de tension et la machine électrique tournante en fermant systématiquement tous les interrupteurs d'un même côté lorsqu'une surtension est détectée. Un tel système ne nécessite par conséquent pas la mise en place de moyens de détection et d'identification de défaut au niveau de chaque interrupteur. Il est donc moins volumineux et moins coûteux à mettre en œuvre que d'autres systèmes de commande.

Néanmoins, un tel systématisme expose les interrupteurs, par exemple des transistors MOSFET, sous une forte contrainte en raison de l'intensité des courants qui les traverse en court-circuit, qui provoque nécessairement une élévation de leur température. Ces courants et la température qui en résulte affectent la durée de vie des transistors et donc du convertisseur de tension. En outre, le rendement du convertisseur de tension s'en trouve dégradé.

L'invention vise donc à résoudre les inconvénients de l'état de la technique en proposant notamment un fonctionnement réduisant la contrainte exercée sur les interrupteurs.

### PRESENTATION DE L'INVENTION

Selon un premier aspect de l'invention, celle-ci a trait à un système de commande d'un convertisseur de tension, le convertisseur de tension étant configuré pour connecter une machine électrique tournante à une source de tension continue, notamment à un réseau de bord, le convertisseur de tension comprenant une pluralité de bras de commutation montés en parallèle, chaque bras comprenant au moins un interrupteur de côté haut et un au moins interrupteur de côté bas connectés l'un à l'autre en un point milieu configuré pour être connecté à ladite machine électrique tournante, les interrupteurs de côté haut formant un groupe haut et les interrupteurs de côtés bas formant un groupe bas, le système de commande comprenant :
- un premier module de mesure d'une tension de la source de tension continue ;
- un module de comparaison de la tension mesurée à un premier seuil de sécurité ;
- un deuxième module de mesure configuré pour mesurer une vitesse de rotation de la machine électrique tournante ;
- un module de commande générant une première commande de court-circuit si le module de comparaison indique que la tension mesurée est supérieure à un premier seuil de sécurité, la première commande de court-circuit consistant en une commande de fermeture d'un premier groupe d'interrupteurs choisi entre le groupe haut et le groupe bas et en une commande d'ouverture d'un deuxième groupe d'interrupteurs comprenant les interrupteurs du groupe haut ou du groupe bas qui ne forment pas le premier groupe,

Le système de commande est remarquable en ce que le module de commande génère ensuite une commande en circuit ouvert, la commande en circuit ouvert consistant en une commande d'ouverture du premier groupe d'interrupteurs et en une commande d'ouverture du deuxième groupe d'interrupteurs :
- si une variation dans le temps de la tension mesurée de la source de tension continue est inférieure à une première variation de sécurité et
- si la vitesse de rotation mesurée par le deuxième module de mesure est inférieure à une première vitesse de sécurité.

Par interrupteur de côté haut ou de côté bas, on entend un interrupteur électronique d'alimentation, par exemple de type transistor IGBT (de l'anglais Insulated Gate Bipolar Transistor) ou encore de type transistor à effet de champ métal-oxyde, connu aussi sous l'acronyme MOSFET de l'anglais (Metal Oxide Semiconductor Field Effect Transistor).

Grâce à une telle combinaison de caractéristiques, un tel module de commande des interrupteurs en circuit ouvert permet d'interrompre la circulation de courant dans le convertisseur de tension lorsque la tension mesurée est stabilisée, réduisant la durée de sollicitation des interrupteurs du groupe haut et du groupe bas, le court-circuit étant évité. La production de chaleur des interrupteurs par effet Joule est ainsi réduite dans l'ensemble du convertisseur de tension.

La première commande de court-circuit est interrompue au profit de la commande en circuit ouvert dès lors que les critères sur la variation dans le temps de la tension et sur la vitesse de rotation sont vérifiés. Dès lors que l'un des critères n'est plus respecté, la commande en circuit ouvert en interrompue.

Avantageusement, le module de commande génère la commande en circuit ouvert si la tension mesurée est inférieure à une première limite, notamment supérieure à 110% du premier seuil de sécurité.

Avantageusement, le module de comparaison compare la tension mesurée à un deuxième seuil de sécurité supérieur au premier seuil de sécurité et le module de commande génère une deuxième commande de court-circuit lorsque la tension mesurée est supérieure ou égale au deuxième seuil de sécurité. La deuxième commande de court-circuit consistant en une commande de de fermeture du deuxième groupe d'interrupteurs et une commande d'ouverture du premier groupe d'interrupteurs.

Un tel système de commande permet de mettre le convertisseur de tension en sécurité dès lors que l'un des interrupteurs du convertisseur de tension est en court-circuit ou en circuit ouvert.

Avantageusement, le module de commande génère ensuite la commande en circuit ouvert :
- si la vitesse de rotation mesurée est inférieure à une deuxième vitesse de sécurité, et
- si la variation dans le temps de la tension mesurée de la source de tension continue est inférieure à une deuxième variation de sécurité.

Avantageusement, le module de commande génère la commande en circuit ouvert si la tension mesurée est inférieure à une deuxième limite, notamment égale au deuxième seuil de sécurité.

La deuxième commande de court-circuit est interrompue au profit de la commande en circuit ouvert dès lors que les critères sur la variation dans le temps de la tension et sur la vitesse de rotation sont vérifiés. Dès lors que l'un des critères n'est plus respecté, la commande en circuit ouvert en interrompue.

La deuxième commande en court-circuit n'est pas interrompue au profit de la première commande en court-circuit lorsque la tension mesurée est inférieure au deuxième seuil de sécurité.

Avantageusement, la commande en circuit ouvert succède à la première commande de court-circuit. Avantageusement, la commande en circuit ouvert succède à la deuxième commande de court-circuit.

Avantageusement; lorsque la tension mesurée est inférieure à une troisième limite, notamment égale au première seuil de sécurité, le module de commande génère des commandes de fonctionnement normal, par exemple dans un mode moteur de la machine électrique tournante, par exemple dans un mode générateur de la machine électrique tournante. Le système de commande est alors réhabilité.

Avantageusement, le premier seuil de sécurité est compris entre 110% et 125% de la tension nominale de la source de tension continue d'alimentation du convertisseur, par exemple 120% de la tension nominale de la source de tension continue. Par exemple, la tension nominale d'alimentation est égale à 48V, et le premier seuil de sécurité est compris entre 53V et 60V.

Avantageusement, le deuxième seuil de sécurité est compris entre 120% et 140% de la tension nominale de la source de tension continue du convertisseur de tension, par exemple 133% de la tension nominale de la source de tension continue. Par exemple. Par exemple, la tension nominale d'alimentation est égale à 48V, et le deuxième seuil de sécurité est compris entre 58V et 67V.

Avantageusement, la première vitesse de sécurité et/ou la deuxième vitesse de sécurité sont la vitesse pour laquelle une force électromotrice de la machine électrique tournante est inférieure à une tension donnée, par exemple 48V. Avantageusement la première vitesse de sécurité est égale à la deuxième vitesse de sécurité. Dans une telle configuration, le module de commande est ainsi assuré de ne commander l'ouverture des groupes hauts et bas que dans le cas où la vitesse de rotation de la machine tournante est faible, par exemple suite à une décision d'un conducteur de véhicule de réduire la vitesse du véhicule, ou par la présence d'un système de déconnexion de la machine électrique du système de commande, amenant la vitesse à baisser.

Avantageusement, la première variation de sécurité est négative, notamment inférieur à -0,2 V/µs. Avantageusement, la deuxième variation de sécurité est négative, notamment inférieur à -0,2 V/µs. Avantageusement, la première variation de sécurité est égale à la deuxième variation de sécurité. Une variation supérieure à cette variation de sécurité traduit l'éventualité selon laquelle une surtension se produit dans le convertisseur de tension, par exemple dû à une chute de charge.

Avantageusement la première limite est supérieure au premier seuil de sécurité. La première limite peut être comprise entre 110% et 125% de la tension nominale de la source de tension continue du convertisseur de tension, par exemple 133% de la tension nominale de la source de tension continue.

Avantageusement la deuxième limite est inférieure au deuxième seuil de sécurité. La deuxième limite est supérieure au deuxième seuil de sécurité. La deuxième limite peut être comprise entre 120% et 150% de la tension nominale de la source de tension continue du convertisseur de tension, par exemple 133% de la tension nominale de la source de tension continue.

Avantageusement la troisième limite est inférieure au premier seuil de sécurité. La troisième limite peut être comprise entre 100% et 125% de la tension nominale de la source de tension continue du convertisseur de tension, par exemple 115% de la tension nominale de la source de tension continue.

Avantageusement, le premier groupe d'interrupteurs est le groupe bas.

Avantageusement, le premier groupe d'interrupteurs est le groupe des interrupteurs de côté haut.

Avantageusement, la tension mesurée par le premier module de mesure est la tension entre deux bornes du convertisseur de tension configurées pour être connectées à la source de tension continue.

Selon un autre aspect de l'invention, celle-ci a trait à un système électrique comprenant :
- une première et une deuxième borne d'alimentation configurées pour être reliées à une source de tension continue, notamment à une batterie d'un véhicule automobile ;
- une machine électrique tournante comprenant un stator ayant au moins trois phases ;
- un convertisseur de tension pour alimenter la machine électrique tournante à partie de ladite source de tension continue, le convertisseur de tension comprenant une pluralité de bras de commutation montés en parallèle, chaque bras comprenant un interrupteur de côté haut et un interrupteur de côté bas connectés l'un à l'autre en un point milieu, chaque point milieu étant connecté à au moins une phase de ladite machine électrique tournante et une unité de commande des interrupteurs de côté haut et de côté bas, ladite unité de commande comprenant un système de commande selon l'une quelconque des revendications précédentes.

Avantageusement, l'unité de commande comprend en outre :
- un contrôleur configuré pour commander les interrupteurs de côté haut et de côté bas,
- un module de contrôle machine configurée pour recevoir d'une unité de commande électronique du véhicule une consigne pour soit mettre la machine électrique tournante en mode moteur, soit mettre la machine électrique tournante en mode alternateur, et agencée pour transformer cette consigne en une commande pour commander les interrupteurs de côté haut et de côté bas du convertisseur de tension,
- un module logique pour prioriser les commandes émises par le système de commande par rapport aux commandes émises par le module de contrôle machine, le module logique transmettant au contrôleur la commande des interrupteurs reçue soit par le module de contrôle machine soit par le système de commande.

Avantageusement, l'unité de commande comprend en outre au moins un module de détection d'un défaut, par exemple un module de défaut de sens du courant de phase, et dans lequel lorsque le module de défaut détecte un défaut, l'unité de commande génère une première commande de court-circuit ou une deuxième commande de court-circuit ou une première commande de court-circuit puis une deuxième commande de court-circuit.

Selon un autre aspect de l'invention, celle-ci a trait à un engin de mobilité comprenant un système électrique tel que décrit précédemment.

Selon un autre aspect de l'invention, celle-ci a trait à un procédé de commande d'un système de commande d'un convertisseur de tension tel que décrit précédemment, le convertisseur de tension étant connecté à une machine électrique tournante et à une source de tension continue, notamment à un réseau de bord, ledit procédé comprenant :
- une mesure par un premier module de mesure d'une tension de la source de tension continue ;
- une mesure par un deuxième module de mesure d'une vitesse de rotation de la machine électrique ;
- une comparaison par un module de mesure de la tension mesurée à un premier seuil de sécurité et une comparaison d'une variation dans le temps de la tension mesurée à une variation de sécurité ;
- une comparaison de la vitesse de rotation mesurée à une vitesse de sécurité ;
- une génération par le module de commande d'une commande d'ouverture d'un premier groupe d'interrupteurs choisi entre groupe d'interrupteurs de côté haut et un groupe d'interrupteurs de côté bas si le module de comparaison indique que la tension mesurée est supérieure à un premier seuil de sécurité et si une variation dans le temps de la tension mesurée de la source de tension continue est inférieure à une variation de sécurité et si la vitesse de rotation mesurée par le deuxième module de mesure est inférieure à une vitesse de sécurité.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
La figure 1 est une représentation schématique d'un système électrique comprenant une unité de commande d'un convertisseur de tension selon un premier aspect de l'invention ;
La figure 2 est une représentation schématique de l'unité de commande de la figure 1 comprenant un système de commande d'un convertisseur de tension selon un autre aspect de l'invention.
La figure 3 est un histogramme représentant la tension mesurée aux bornes d'une source de tension continue selon un premier cas d'utilisation du système de commande de la figure 1.
La figure 4 est un histogramme représentant la tension mesurée aux bornes d'une source de tension continue selon un autre cas d'utilisation du système de commande de la figure 1.

Il faut noter que les figures exposent l'invention de manière détaillée pour permettre de mettre en œuvre l'invention ; bien que non limitatives, lesdites figures servent notamment à mieux définir l'invention le cas échéant.

### DESCRIPTION DETAILLEE DE L'INVENTION

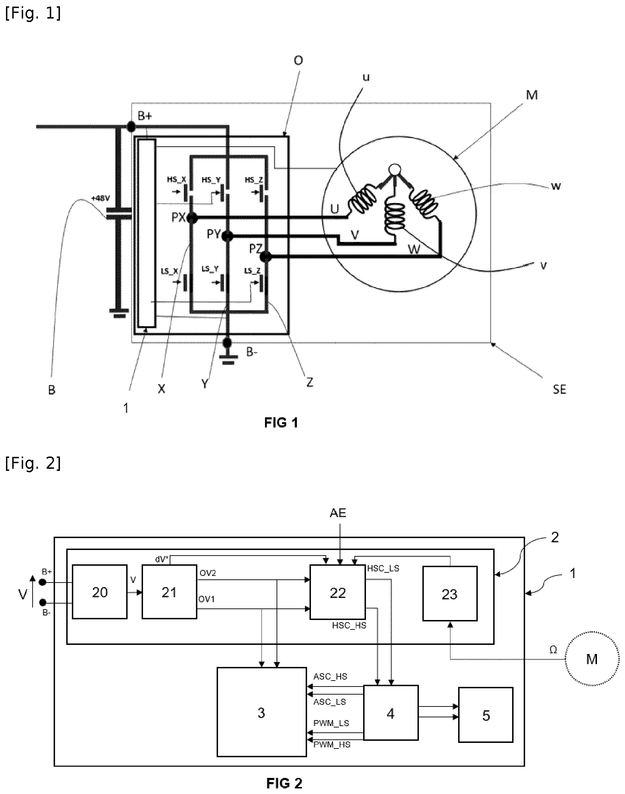

Sur la figure 1 est illustré un système électrique SE comprenant une première borne d'alimentation B+ et une deuxième borne d'alimentation B- reliées à une source d'alimentation continue B par exemple une batterie d'un véhicule automobile permettant d'alimenter d'autres équipements électriques non représentés du véhicule par le biais d'un réseau de bord. La tension aux bornes B+, B- de la source de tension continue B est par exemple de 48 V, ce qui correspond à une application dite « basse tension ». Ici, la deuxième borne B- est la masse du système électrique SE.

Le système électrique SE comprend une machine électrique tournante M comprenant un stator ayant au moins trois phases U, V, W et trois bobines u, v, w bobinées dans le stator. Dans cet exemple, les bobines u, v, w sont montées en étoile et comprennent chacune à leur sortie la phase correspondante U, V, W respectivement.

Le système électrique SE comprend en outre un convertisseur de tension O pour alimenter la machine électrique tournante M à partie de ladite source de tension continue B. Dans une telle configuration, les phases U, V, W de la machine électrique M sont alimentées par le convertisseur de tension d'un courant alternatif triphasé.

Le convertisseur de tension O comprend une pluralité de bras de commutation montés en parallèle entre les bornes B+ et B-. Le convertisseur de tension O comprend autant de bras que la machine électrique tournante M possède de phases. En l'occurrence, dans l'exemple décrit ici, le convertisseur de tension O comprend trois bras. Ainsi, le convertisseur de tension O comprend un premier bras X, un deuxième bras Y et un troisième bras Z.

Chaque bras X, Y, Z comprend un interrupteur dit de côté haut HS_X, HS _Y, HS_Z et un interrupteur de côté bas LS_X, LS_Y, LS_Z. Chaque interrupteur côté haut et côté bas d'un bras X, Y, Z sont connectés l'un à l'autre en un point milieu PX, PY, PZ. Les interrupteurs de côté haut forme un groupe d'interrupteur, dit groupe haut HS. De même, les interrupteurs de côté bas forme un groupe d'interrupteur, dit groupe bas LS. Les interrupteurs du groupe bas LS et du groupe haut type HS sont ici des transistors à effet de champ métal-oxyde, connu aussi sous l'acronyme MOSFET de l'anglais (Metal Oxide Semiconductor Field Effect Transistor).

Dans l'exemple décrit ici, chaque interrupteur de côté haut ou de côté bas est un transistor à effet de champ métal-oxyde comprenant chacun une diode de roue libre.

En l'occurrence, dans cet exemple, il y a donc sur le premier bras X un premier interrupteur de côté haut HS_X relié à un premier interrupteur de côté bas LS_X par un premier point milieu PX, sur le deuxième bras Y un deuxième interrupteur de côté haut HS_Y relié à un deuxième interrupteur de côté bas LS_Y par un deuxième point milieu PY et un troisième interrupteur de côté haut HS_Z, respectivement relié à un troisième interrupteur de côté bas LS_Z par un troisième point milieu PZ.

Chaque point milieu PX, PY, PZ est connecté à au moins une phase U, V, W de ladite machine électrique tournante M, soit en l'occurrence dans cet exemple le premier point milieu PX à la phase U, le deuxième point milieu PY à la phase V et le troisième point milieu Z à la phase W.

Le convertisseur de tension O comprend en outre une unité de commande 1 des interrupteurs de côté haut HS_X, HS_Y, HS_Z et de côté bas LS_X, LS_Y, LS_Z. Ladite unité de commande 1 comprend donc pour chaque interrupteur une sortie reliée à la commande de l'interrupteur correspondant. Pour ne pas surcharger la figure 1, uniquement la liaison entre une sortie de l'unité de commande 1 et la commande du troisième interrupteur de côté bas LS_Z et une autre sortie de l'unité de commande 1 et la commande du deuxième interrupteur de côté haut HS_Y ont été représentées.

L'unité de commande 1 contrôle les interrupteurs de chaque bras X, Y, Z en modulation de largeur d'impulsion MLI, également désignée sous l'acronyme anglais « PWM » pour « Pulse Width Modulation ».

Sur la figure 2 est illustrée l'unité de commande de la figure 1 comprenant un système de commande 2 du convertisseur de tension 2 selon un autre aspect de l'invention.

L'unité de commande 1 comprend un système de commande 2 comprenant un premier module de mesure 20 d'une tension de la source de tension continue B. Dans l'exemple décrit ici, le premier module de mesure 20 mesure une tension V aux bornes B+ et B-. En d'autres termes, dans l'exemple décrit ici, le premier module de mesure 20 mesure la tension de la source de tension continue B, ayant ici une tension nominale de 48 V.

Le système de commande 2 comprend un module de comparaison 21 configuré pour recevoir une information de la tension V mesurée par le module de mesure 20. Le module de comparaison 21 compare la tension V mesurée à un premier seuil de sécurité OV1. Le premier seuil de sécurité OV1 est par exemple stocké dans une mémoire permanente du module de comparaison 21. Une troisième limite à laquelle est comparée la tension V est également stockée dans la mémoire permanente du module de comparaison 21. La valeur de la troisième limite est ici égale à la valeur du premier seuil de sécurité.

Le système de commande 2 comprend un deuxième module de mesure 23 configuré pour mesurer une vitesse de rotation Ω de la machine électrique M. Le deuxième module de mesure 23 actualise la mesure réalisée selon une durée paramétrable, par exemple toutes les 100 ms.

Le premier seuil de sécurité OV1 est notamment compris entre 110% et 125% de la tension nominale V de la source de tension continue B d'alimentation du convertisseur O, par exemple 120% de la tension nominale V de la source de tension continue. Ici, le premier seuil de sécurité OV1 est égal à 56 V.

Le module de comparaison 21 est en outre configuré pour comparer la tension V mesurée à un deuxième seuil de sécurité OV2, supérieure au premier seuil de sécurité OV1. Le deuxième seuil de sécurité OV2 est par exemple stocké dans une mémoire permanente du module de comparaison 21. Le module de comparaison 21 est également configuré pour calculer une variation dans le temps dV* de la tension V à partir de deux mesures successives de la tension V. Une deuxième limite à laquelle est comparée la tension V est également stockée dans la mémoire permanente du module de comparaison 21. La valeur de la deuxième limite est ici égale à la valeur du deuxième seuil de sécurité.

Le deuxième seuil de sécurité OV2 est notamment compris entre 120% et 140% de la tension nominale V de la source de tension continue B du convertisseur de tension O, par exemple 133% de la tension nominale V de la source de tension continue B. Ici, le deuxième seuil de sécurité OV2 est égal à 64 V.

Le système de commande 2 comprend en outre un module de commande 22. Dans l'exemple décrit ici, le module de commande 22 est réalisé à partir de portes logiques. En variante, le module de commande 22 peut être un microcontrôleur
Le module de comparaison 21 transmet au module de commande 22 l'information du premier seuil de sécurité OV1, par exemple sous la forme d'un niveau logique haut lorsque la tension mesurée V est supérieure au premier seuil de sécurité OV1, et d'un niveau logique bas sinon.

Le module de comparaison 21 transmet au module de commande 22 l'information du deuxième seuil de sécurité OV2, par exemple sous la forme d'un niveau logique haut lorsque la tension mesurée V est supérieure au deuxième seuil de sécurité OV2, et d'un niveau logique bas sinon.

Sur réception de l'information correspondant au premier seuil de sécurité OV1, le module de commande 22 émet une première commande de court-circuit consistant en une commande de fermeture d'un premier groupe d'interrupteurs LS, HS, choisi parmi le groupe des interrupteurs de côté haut c'est-à-dire le groupe haut HS ou le groupe des interrupteurs de côté bas c'est-à-dire le groupe bas LS et en une commande d'ouverture d'un deuxième groupe d'interrupteurs comprenant les interrupteurs du groupe haut ou du groupe bas qui ne forment pas le premier groupe. Dans l'exemple décrit, le premier groupe d'interrupteurs est le groupe bas LS et le deuxième groupe d'interrupteurs est le groupe haut HS. la première commande de court-circuit ASC_LS est une commande de fermeture de tous les interrupteurs du groupe bas LS et une commande de fermeture de tous les interrupteurs du groupe bas LS.

Le module de commande 22 reçoit en outre une information de la variation de tension dV* issue du module de comparaison 21 et une information de la vitesse Ω issue du deuxième module de mesure 23.

Partant de l'état dans lequel tous interrupteurs du groupe bas LS sont fermées et dans lequel tous les interrupteurs du groupe haut HS sont ouverts. Dans le cas où la variation de tension dV* est inférieure à une première variation de sécurité et où la vitesse de rotation Ω est inférieure à une première vitesse de sécurité, le module de commande 22 génère ensuite une commande en circuit ouvert, consistant en une commande d'ouverture tous les interrupteurs du groupe bas LS et de tous les interrupteurs du groupe haut HS.

Une telle configuration des interrupteurs place le convertisseur de tension O en circuit ouvert et permet d'interrompre momentanément la circulation de courant dans le convertisseur de tension O lorsque la tension mesurée est considérée comme stable, ce qui réduit la durée de sollicitation des interrupteurs, le court-circuit étant évité. La production de chaleur des interrupteurs par effet Joule est ainsi réduite dans l'ensemble du convertisseur de tension.

La première variation de sécurité est de préférence inférieure à -0,2 V/µs. La première vitesse de sécurité est la vitesse pour laquelle une force électromotrice de la machine électrique M est inférieure à 48 V.

Sur réception de l'information correspondant au franchissement du deuxième seuil de sécurité OV2, le module de commande 22 émet une deuxième commande de court-circuit ASC_HS. La deuxième commande de court-circuit consistant ici en une commande de fermeture du deuxième groupe d'interrupteurs e, ici le groupe haut HS et en une commande d'ouverture du premier groupe d'interrupteurs, ici le groupe bas LS.

Le module de commande 22 reçoit, à nouveau, l'information de la variation de tension dV* issue du module de comparaison 21 et l'information de la vitesse Ω issue du deuxième module de mesure 23.

Partant de l'état dans lequel tous interrupteurs du groupe bas LS sont ouverts et dans lequel tous les interrupteurs du groupe haut HS sont fermés. Dans le cas si la tension mesurée V est inférieure au deuxième seuil de sécurité OV2, et où la variation de tension dV* est inférieure à une deuxième variation de sécurité et où la vitesse de rotation Ω est inférieure à une deuxième vitesse de sécurité, le module de commande 22 génère ensuite la commande en circuit ouvert.

Dans l'exemple décrit, la valeur de la deuxième variation est égale à la valeur de la première variation. Ici -0,2 V/µs. Dans l'exemple décrit la deuxième vitesse de sécurité est égale à la première vitesse de sécurité.

De façon optionnelle, le module de commande 12 peut également comprendre une ou plusieurs entrées AE agencées pour recevoir des informations d'erreur, par exemple, une information d'erreur relative à une tension trop basse sur le réseau de bord (en anglais Under Voltage ou UV). Sur réception d'une information d'erreur sur la ou les entrées AE, le module de commande 22 peut émettre également une commande de fermeture du premier groupe d'interrupteurs et éventuellement une commande d'ouverture du deuxième groupe d'interrupteurs.

Dans le mode de réalisation décrit ici, l'unité de commande 1 comprend en outre un module de contrôle machine 3, un module logique 4 et un contrôleur 5 également désigné sous le terme anglais « driver ».

Le module de contrôle machine 3 comprend une entrée (non représentée) pour recevoir d'une unité de commande électronique du véhicule une consigne pour soit mettre la machine électrique tournante M en mode moteur selon une valeur de couple fournie, soit mettre la machine électrique tournante M en mode alternateur selon un couple résistif pour recharger la source de tension continue du véhicule. Le module de contrôle machine 3 transforme cette consigne en une commande des interrupteurs de côté haut HS et de côté bas LS, ladite commande étant transmise par le biais du module logique 4 et du contrôleur 5. En d'autres termes, grâce au module de contrôle machine 3, du module logique 4 et du contrôleur 5, les interrupteurs de côté haut HS et les interrupteurs de côté bas LS reçoivent chacun une commande, par exemple par modulation de largeur d'impulsion PWM_HS, PWM_LS, d'ouverture ou de fermeture.

Notamment, le module logique 3 est configuré pour prioriser les commandes émises par le système de commande 2 par rapport aux commandes émises par le module de contrôle machine 2. Autrement dit, le système de commande 2 est alors prioritaire sur le module de contrôle machine 3. Lorsque le module de contrôle machine 3 est un microprocesseur et lorsque le module de commande 22 et le module de logique 4 sont réalisés en utilisant des portes logiques, le temps de réaction du module de contrôle machine 3 (typiquement de l'ordre de la dizaine de microsecondes) est plus long que le temps de réaction du module de commande 21 (typiquement de l'ordre de la microseconde). Ainsi, la priorisation effectuée par le module logique 4 permet d'assurer une mise en sécurité plus rapide du convertisseur de tension O et de la machine électrique tournante M.

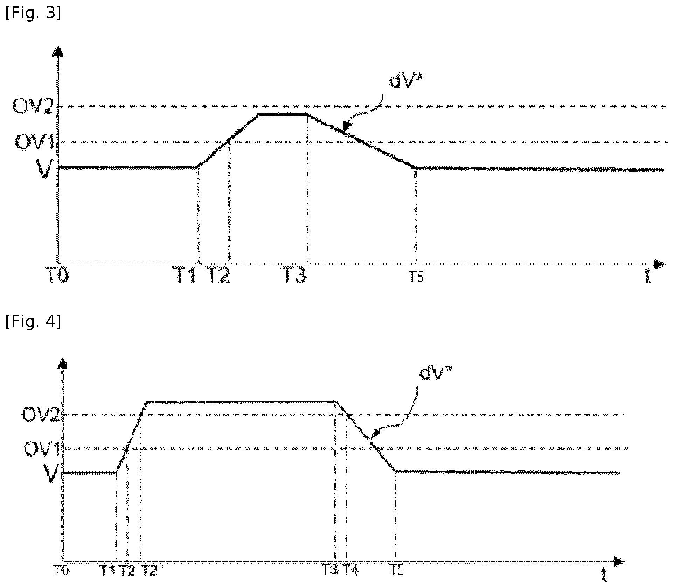

Les figures 3 et 4 illustrent des histogrammes de l'évolution de la tension V mesurée aux bornes B+ et B- dans deux cas d'utilisation du convertisseur de tension O et du système de commande 2 du convertisseur de tension O.

Sur l'histogramme de la figure 3, pendant une première période, ici entre les instants T0 et T2, le convertisseur de tension O commande les interrupteurs de côté haut et de côté bas normalement en fonction de la consigne de l'unité de commande électronique du véhicule. Durant cette période, la tension mesurée V est inférieure au premier seuil de sécurité OV1, notamment pendant une première durée elle est égale à la tension nominale de la source de tension continue B, en l'occurrence 48 Volts. À un instant T1, la première source d'alimentation continue B se déconnecte du réseau de bord alors que la machine électrique tournante est en mode génératrice. Cette déconnexion crée un phénomène de chute de charge (en anglais « load dump ») qui occasionne une surtension sur le réseau de bord. Suite à cette déconnexion, à un instant T2, la tension mesurée V dépasse le premier seuil de sécurité OV1 en l'occurrence de 56 Volts. Le module de comparaison 21 du système de commande 2 envoie alors au module de commande 21 l'information selon laquelle la tension mesurée V est supérieure au premier seuil de sécurité OV1. Sur réception de cette commande, le module de commande 22 génèe la première commande de court-circuit ASC_LS et commande la fermeture des interrupteurs du premier groupe et l'ouverture des interrupteurs du deuxième groupe. En l'occurrence, dans cet exemple le module de commande 22 envoie au module logique 4 une commande de fermeture des interrupteurs de côté bas afin de mettre les phases à la masse et une commande d'ouverture des interrupteurs de côté haut. Le module logique 4 retransmet, quelles que soient les commandes émises par ailleurs par le module de contrôle machine 3, ces commandes au contrôleur 5 pour commander la fermeture des interrupteurs du groupe bas LS, et l'ouverture des interrupteurs du groupe haut HS.

Le module de comparaison 21 calcule la variation dV* et la compare à la première variation de sécurité. Sur la figure 3, la variation dV* correspond à la pente du signal de la tension V. Il apparait que la variation dV* est positive jusqu'à ce que la tension V se stabilise, entre le premier seuil de sécurité OV1 et le deuxième seuil de sécurité OV2. La variation dV* devient ensuite négative à l'instant T3. Instant T3 à partir duquel la variation dV* est inférieure à la première variation de sécurité. Simultanément ou consécutivement, le module de commande 22 compare la vitesse de rotation Ω de la machine électrique tournante M à la première vitesse de sécurité. Sur la figure 3, après l'instant T3, la vitesse de rotation Ω est inférieure à la première vitesse de sécurité de la machine électrique. A l'instant T3, le module de commande 22 génère donc une commande de circuit ouvert et commande l'ouverture des interrupteurs du premier groupe et l'ouverture des interrupteurs du deuxième groupe. En l'occurrence, dans cet exemple le module de commande 22 envoie au module logique 4 une commande d'ouverture des interrupteurs de côté bas et si nécessaire une commande d'ouverture des interrupteurs de côté haut. Le module logique 4 retransmet, quelles que soient les commandes émises par ailleurs par le module de contrôle machine 3, ces commandes au contrôleur 5 pour commander l'ouverture des interrupteurs du groupe bas LS et du groupe haut HS. La tension V aux bornes de la source de tension continue B diminue alors pour retrouver sa valeur nominale, le circuit étant alors ouvert.

Sur l'histogramme de la figure 4, à la différence de l'histogramme de la figure 3, la tension V ne se stabilise pas entre le premier seuil de sécurité OV1, atteint à l'instant T2 et le deuxième seuil de sécurité OV2 atteint à l'instant T2'. Dans ce cas, le module de commande 22 génère successivement la première commande de court-circuit ASC_LS puis la deuxième commande de court-circuit ASC_HS consistant en la commande l'ouverture des interrupteurs du premier groupe et la fermeture des interrupteurs du deuxième groupe. En l'occurrence, dans cet exemple le module de commande 22 envoie au module logique 4 une commande d'ouverture des interrupteurs de côté bas et une commande de fermeture des interrupteurs de côté haut. Le module logique 4 retransmet, quelles que soient les commandes émises par ailleurs par le module de contrôle machine 3, ces commandes au contrôleur 5 pour commander l'ouverture des interrupteurs du groupe bas LS, et la fermeture des interrupteurs du groupe haut HS.

La tension V se stabilise alors à une valeur supérieure au deuxième seuil de sécurité OV2. Le conducteur du véhicule reçoit un signal invitant à réduire l'allure du véhicule, ce qui a pour effet de diminuer la vitesse du véhicule et par conséquent celle de la machine électrique tournante M. Alternativement, le véhicule comprend un dispositif de déconnexion du système de transmission permettant de réduire la vitesse de la machine tournante M. Cette stabilisation montre que le système de commande 2 a appliqué la stratégie correcte de mise en court-circuit des bras de commutation du convertisseur de tension O eu égard au type du défaut ayant engendré la surtension.

Le système de commande 2 peut ainsi, si la vitesse de rotation de la machine électrique tournante M est inférieure à la vitesse de sécurité, générer une commande de circuit ouvert et commander à l'ouverture des groupes hauts et groupes bas pour repasser en circuit ouvert lorsque que la tension mesurée aux bornes de la source de tension continue B passe sous le deuxième seuil de sécurité OV2. C'est ce qui est illustré à la figure 4.

A la figure 4, la variation dV* est positive jusqu'à ce que la tension V se stabilise, au-dessus du deuxième seuil de sécurité OV2. La variation dV* devient ensuite négative à l'instant T3. Instant T3 à partir duquel la variation dV* est inférieure à la première variation de sécurité. Le module de commande 22 compare également la vitesse de rotation Ω de la machine électrique tournante M à la première vitesse de sécurité. Sur la figure 4, après l'instant T3, la vitesse de rotation Ω est inférieure à la première vitesse de sécurité de la machine électrique. A l'instant T4, la tension V devient inférieure au deuxième seuil de sécurité OV2. A l'instant T4, les trois conditions sont réunies et le module de commande 22 génère une commande de circuit ouvert et commande l'ouverture des interrupteurs du premier groupe et l'ouverture des interrupteurs du deuxième groupe.

Aux figures 3 et 4, la tension V redevient inférieure au première seuil de sécurité OV1 à l'instant T5, le module de commande 22 génère à nouveau des commandes de fonctionnement normal, par exemple dans un mode moteur de la machine électrique tournante, par exemple dans un mode générateur de la machine électrique tournante. Le système de commande est alors réhabilité.

On notera par ailleurs que l'invention n'est pas limitée au mode de réalisation décrit précédemment. Il apparaîtra en effet à l'homme de l'art que diverses modifications peuvent être apportées au mode de réalisation décrit ci-dessus, à la lumière de l'enseignement qui vient de lui être divulgué.

Ainsi dans le mode de réalisation précédemment décrit, les interrupteurs du premier groupe sont les interrupteurs de côté bas et les interrupteurs du deuxième groupe les interrupteurs de côte haut mais en variante, les interrupteurs du premier groupe peuvent être les interrupteurs de côté haut et les interrupteurs du deuxième groupe les interrupteurs de côte bas.

De même, la machine tournante précédemment décrite est une machine triphasée. En variante, la machine tournante électrique peut plus généralement avoir n phases, par exemple n=6 pour une machine hexaphasée. Dans ce cas, le convertisseur de tension O comporte également n bras de commutation.

De même, dans le mode de réalisation précédemment décrit, les bobines u, v, w sont montées en étoile. En variante, les bobines u, v, w peuvent être montées en triangle.

De même, dans le mode de réalisation précédemment décrit, le module logique 4, le module de commande 21 et le module de contrôle machine 3 sont réalisés sous forme d'entités distinctes. En variante, le module logique 4, le module de commande 21 et le module de contrôle machine 3 peuvent être réalisés sous la forme d'une seule entité, par exemple un microcontrôleur comportant un circuit logique programmable par exemple du type FPGA (de l'anglais « Field-Programmable Gate Array »)

Dans la présentation détaillée de l'invention qui est faite précédemment, les termes utilisés ne doivent pas être interprétés comme limitant l'invention au mode de réalisation exposé dans la présente description, mais doivent être interprétés pour y inclure tous les équivalents dont la prévision est à la portée de l'homme de l'art en appliquant ses connaissances générales à la mise en œuvre de l'enseignement qui vient de lui être divulgué.

## Revendications

1. Système de commande (2) d'un convertisseur de tension (O), le convertisseur de tension (O) étant configuré pour connecter une machine électrique tournante (M) à une source de tension continue (B), notamment à un réseau de bord, le convertisseur de tension (O) comprenant une pluralité de bras de commutation montés en parallèle (X,Y,Z), chaque bras comprenant au moins un interrupteur de côté haut (HS_X, HS_Y, HS_Z) et un au moins interrupteur de côté bas (LS_X, LS_Y, LS_Z) connectés l'un à l'autre en un point milieu (PX, PY, PZ) configuré pour être connecté à ladite machine électrique tournante (M), les interrupteurs de côté haut formant un groupe haut (HS) et les interrupteurs de côtés bas formant un groupe bas (LS), le système de commande (2) comprenant :
- un premier module de mesure (20) d'une tension (V) de la source de tension continue (B) ;
- un module de comparaison (21) de la tension mesurée (V) à un premier seuil de sécurité (OV1) ;
- un module de commande (22) générant une première commande de court-circuit (ASC_LS) si le module de comparaison (21) indique que la tension (V) mesurée est supérieure à un premier seuil de sécurité (OV1), la première commande de court-circuit consistant en une commande de fermeture d'un premier groupe d'interrupteurs choisi entre le groupe haut et le groupe bas et en une commande d'ouverture d'un deuxième groupe d'interrupteurs comprenant les interrupteurs du groupe haut ou du groupe bas qui ne forment pas le premier groupe,
**caractérisé par** un deuxième module de mesure (23) configuré pour mesurer une vitesse de rotation (Ω) de la machine électrique tournante (M) ; et
en ce que le module de commande (22) génère ensuite une commande en circuit ouvert, la commande en circuit ouvert consistant en une commande d'ouverture du premier groupe d'interrupteurs et en une commande d'ouverture du deuxième groupe d'interrupteurs :
- si une variation dans le temps (dV*) de la tension mesurée (V) de la source de tension continue (B) est inférieure à une première variation de sécurité et
- si la vitesse de rotation mesurée (Ω) par le deuxième module de mesure (23) est inférieure à une première vitesse de sécurité.

2. Système de commande (2) selon la revendication précédente, **caractérisé en ce que** le module de comparaison (21) compare la tension (V) mesurée à un deuxième seuil (OV2) de sécurité supérieur au premier seuil de sécurité (OV1) et **en ce que** le module de commande (22) génère une deuxième commande de court-circuit (ASC_HS), la deuxième commande de court-circuit consistant en une commande de de fermeture du deuxième groupe d'interrupteurs et une commande d'ouverture du premier groupe d'interrupteurs, lorsque la tension mesurée (V) est supérieure ou égale au deuxième seuil de sécurité (OV2).

3. Système de commande (2) selon la revendication précédente, **caractérisé en ce que** le module de commande génère ensuite la commande en circuit ouvert :
- si la vitesse de rotation (Ω) mesurée est inférieure à une deuxième vitesse de sécurité, et
- si la variation dans le temps (dV*) de la tension mesurée (V) de la source de tension continue (B) est inférieure à une deuxième variation de sécurité.

4. Système de commande (2) selon la revendication 1, **caractérisé en ce que** la première vitesse de sécurité est la vitesse pour laquelle une force électromotrice de la machine électrique tournante est inférieure à une tension donnée, par exemple 48V.

5. Système de commande (2) selon l'une des revendications précédentes, **caractérisé en ce que** la première variation de sécurité est négative, notamment inférieure à - 0,2 V/µs.

6. Système de commande (2) selon l'une quelconque des revendications précédentes, **caractérisé en ce que** le premier groupe d'interrupteurs est le groupe bas.

7. Système de commande (2) selon l'une quelconque des revendications précédentes, **caractérisé en ce que** la tension mesurée (V) par le premier module de mesure est la tension entre deux bornes (B+, B-) du convertisseur de tension (O) configurées pour être connectées à la source de tension continue (B).

8. Système électrique (SE) comprenant :
- une première (B+) et une deuxième (B-) bornes d'alimentation configurée pour être reliées à la source de tension continue (B), notamment à une batterie d'un véhicule automobile ;
- la machine électrique tournante (M) comprenant un stator ayant au moins trois phases (U, V, W) ;
- le convertisseur de tension (O), chaque point milieu (PX, PY, PZ) du convertisseur de tension (O) étant connecté à au moins une des phases (U, V, W) de ladite machine électrique tournante (M) et une unité de commande (1) des interrupteurs de côté haut et de côté bas, ladite unité de commande (1) comprenant le système de commande (2) selon l'une quelconque des revendications précédentes.

9. Système électrique (SE) selon la revendication 8, **caractérisé en ce que** l'unité de commande (1) comprend en outre :
- un contrôleur (5) configuré pour commander les interrupteurs de côté haut et de côté bas,
- un module de contrôle machine (3) configuré pour recevoir d'une unité de commande électronique du véhicule une consigne pour soit mettre la machine électrique tournante (M) en mode moteur, soit mettre la machine électrique tournante (M) en mode alternateur, et agencé pour transformer cette consigne en une commande pour commander les interrupteurs de côté haut et de côté bas du convertisseur de tension (O),
- un module logique (4) pour prioriser les commandes émises par le système de commande (2) par rapport aux commandes émises par le module de contrôle machine (3), le module logique (4) transmettant au contrôleur (5) la commande des interrupteurs reçue soit par le module de contrôle machine (3) soit par le système de commande (2).

10. Engin de mobilité **caractérisé en ce qu'**il comprend un système électrique (SE) selon l'une quelconque des revendications 8 à 9.

## Patentansprüche

1. Steuerungssystem (2) eines Spannungswandlers (0), wobei der Spannungswandler (0) dazu konfiguriert ist, eine rotierende elektrische Maschine (M) mit einer Gleichspannungsquelle (B), insbesondere mit einem Bordnetz, zu verbinden, wobei der Spannungswandler (0) eine Vielzahl von parallel geschalteten Schaltarmen (X, Y, Z) umfasst, wobei jeder Arm mindestens einen High-Side-Schalter (HS_X, HS_Y, HS_Z) und mindestens einen Low-Side-Schalter (LS_X, LS_Y, LS_Z) umfasst, die miteinander an einem Mittelpunkt (PX, PY, PZ) verbunden sind, der dazu konfiguriert ist, mit der rotierenden elektrischen Maschine (M) verbunden zu werden, wobei die High-Side-Schalter eine High-Side-Gruppe (HS) und die Low-Side-Schalter eine Low-Side-Gruppe (LS) bilden, wobei das Steuerungssystem (2) umfasst:
- ein erstes Messmodul (20) einer Spannung (V) der Gleichspannungsquelle (B);
- ein Vergleichsmodul (21) der gemessenen Spannung (V) mit einem ersten Sicherheitsschwellenwert (OV1);
- ein Steuermodul (22), das einen ersten Kurzschlussbefehl (ASC_LS) erzeugt, wenn das Vergleichsmodul (21) anzeigt, dass die gemessene Spannung (V) größer als ein erster Sicherheitsschwellenwert (OV1) ist, wobei der erste Kurzschlussbefehl aus einem Schließbefehl für eine erste Schaltergruppe, die zwischen der High-Side-Gruppe und der Low-Side-Gruppe gewählt wird, und einem Öffnungsbefehl für eine zweite Schaltergruppe besteht, die die Schalter der High-Side-Gruppe oder der Low-Side-Gruppe umfasst, die nicht die erste Gruppe bilden,
**gekennzeichnet durch** ein zweites Messmodul (23), das dazu konfiguriert ist, eine Drehzahl (Ω) der rotierenden elektrischen Maschine (M) zu messen; und
**dadurch, dass** das Steuermodul (22) anschließend einen Leerlaufbefehl erzeugt, wobei der Leerlaufbefehl aus einem Öffnungsbefehl für die erste Schaltergruppe und einem Öffnungsbefehl für die zweite Schaltergruppe besteht:
- wenn eine zeitliche Änderung (dV*) der gemessenen Spannung (V) der Gleichspannungsquelle (B) kleiner als eine erste Sicherheitsänderung ist und
- wenn die vom zweiten Messmodul (23) gemessene Drehzahl (Ω) kleiner als eine erste Sicherheitsdrehzahl ist.

2. Steuerungssystem (2) nach dem vorhergehenden Anspruch, **dadurch gekennzeichnet, dass** das Vergleichsmodul (21) die gemessene Spannung (V) mit einem zweiten Sicherheitsschwellenwert (OV2) vergleicht, der größer als der erste Sicherheitsschwellenwert (OV1) ist, und dass das Steuermodul (22) einen zweiten Kurzschlussbefehl (ASC_HS) erzeugt, wobei der zweite Kurzschlussbefehl aus einem Schließbefehl für die zweite Schaltergruppe und einem Öffnungsbefehl für die erste Schaltergruppe besteht, wenn die gemessene Spannung (V) größer oder gleich dem zweiten Sicherheitsschwellenwert (OV2) ist.

3. Steuerungssystem (2) nach dem vorhergehenden Anspruch, **dadurch gekennzeichnet, dass** das Steuermodul anschließend den Leerlaufbefehl erzeugt:
- wenn die gemessene Drehzahl (Ω) kleiner als eine zweite Sicherheitsdrehzahl ist, und
- wenn die zeitliche Änderung (dV*) der gemessenen Spannung (V) der Gleichspannungsquelle (B) kleiner als eine zweite Sicherheitsänderung ist.

4. Steuerungssystem (2) nach Anspruch 1, **dadurch gekennzeichnet, dass** die erste Sicherheitsdrehzahl die Drehzahl ist, bei der eine elektromotorische Kraft der rotierenden elektrischen Maschine kleiner als eine gegebene Spannung ist, beispielsweise 48 V.

5. Steuerungssystem (2) nach einem der vorhergehenden Ansprüche, **dadurch gekennzeichnet, dass** die erste Sicherheitsänderung negativ ist, insbesondere kleiner als - 0,2 V/µs.

6. Steuerungssystem (2) nach einem der vorhergehenden Ansprüche, **dadurch gekennzeichnet, dass** die erste Schaltergruppe die Low-Side-Gruppe ist.

7. Steuerungssystem (2) nach einem der vorhergehenden Ansprüche, **dadurch gekennzeichnet, dass** die vom ersten Messmodul gemessene Spannung (V) die Spannung zwischen zwei Anschlüssen (B+, B-) des Spannungswandlers (0) ist, die dazu konfiguriert sind, mit der Gleichspannungsquelle (B) verbunden zu werden.

8. Elektrisches System (SE), umfassend:
- einen ersten (B+) und einen zweiten (B-) Versorgungsanschluss, die dazu konfiguriert sind, mit der Gleichspannungsquelle (B), insbesondere mit einer Batterie eines Kraftfahrzeugs, verbunden zu werden;
- die rotierende elektrische Maschine (M), die einen Stator mit mindestens drei Phasen (U, V, W) umfasst;
- den Spannungswandler (0), wobei jeder Mittelpunkt (PX, PY, PZ) des Spannungswandlers (0) mit mindestens einer der Phasen (U, V, W) der rotierenden elektrischen Maschine (M) verbunden ist, und eine Steuereinheit (1) der High-Side- und Low-Side-Schalter, wobei die Steuereinheit (1) das Steuerungssystem (2) nach einem der vorhergehenden Ansprüche umfasst.

9. Elektrisches System (SE) nach Anspruch 8, **dadurch gekennzeichnet, dass** die Steuereinheit (1) ferner umfasst:
- einen Regler (5), der dazu konfiguriert ist, die High-Side- und Low-Side-Schalter zu steuern,
- ein Maschinensteuermodul (3), das dazu konfiguriert ist, von einer elektronischen Steuereinheit des Fahrzeugs eine Vorgabe zu empfangen, um entweder die rotierende elektrische Maschine (M) in den Motorbetrieb zu versetzen oder die rotierende elektrische Maschine (M) in den Generatorbetrieb zu versetzen, und das dazu ausgelegt ist, diese Vorgabe in einen Befehl zur Steuerung der High-Side- und Low-Side-Schalter des Spannungswandlers (0) umzuwandeln,
- ein Logikmodul (4) zur Priorisierung der vom Steuerungssystem (2) ausgegebenen Befehle gegenüber den vom Maschinensteuermodul (3) ausgegebenen Befehlen, wobei das Logikmodul (4) dem Regler (5) den Schaltbefehl übermittelt, der entweder vom Maschinensteuermodul (3) oder vom Steuerungssystem (2) empfangen wurde.

10. Mobilitätsfahrzeug, **dadurch gekennzeichnet, dass** es ein elektrisches System (SE) nach einem der Ansprüche 8 bis 9 umfasst.

## Claims

1. Control system (2) of a voltage converter (0), the voltage converter (0) being configured to connect a rotating electrical machine (M) to a direct voltage source (B), in particular to an on-board network, the voltage converter (0) comprising a plurality of switching arms mounted in parallel (X, Y, Z), each arm comprising at least one high-side switch (HS_X, HS_Y, HS_Z) and at least one low-side switch (LS_X, LS_Y, LS_Z) connected to one another at a midpoint (PX, PY, PZ) configured to be connected to said rotating electrical machine (M), the high-side switches forming a high group (HS) and the low-side switches forming a low group (LS), the control system (2) comprising:
- a first measurement module (20) of a voltage (V) of the direct voltage source (B);
- a comparison module (21) of the measured voltage (V) against a first safety threshold (OV1);
- a control module (22) generating a first short-circuit command (ASC_LS) if the comparison module (21) indicates that the measured voltage (V) exceeds a first safety threshold (OV1), the first short-circuit command consisting of a closing command of a first group of switches chosen between the high group and the low group and an opening command of a second group of switches comprising the switches of the high group or the low group that do not form the first group,
**characterised by** a second measurement module (23) configured to measure a rotational speed (Ω) of the rotating electrical machine (M); and
in that the control module (22) subsequently generates an open-circuit command, the open-circuit command consisting of an opening command of the first group of switches and an opening command of the second group of switches:
- if a time variation (dV*) of the measured voltage (V) of the direct voltage source (B) is less than a first safety variation, and
- if the rotational speed (Ω) measured by the second measurement module (23) is less than a first safety speed.

2. Control system (2) according to the preceding claim, **characterised in that** the comparison module (21) compares the measured voltage (V) against a second safety threshold (OV2) higher than the first safety threshold (OV1) and **in that** the control module (22) generates a second short-circuit command (ASC_HS), the second short-circuit command consisting of a closing command of the second group of switches and an opening command of the first group of switches, when the measured voltage (V) is greater than or equal to the second safety threshold (OV2).

3. Control system (2) according to the preceding claim, **characterised in that** the control module subsequently generates the open-circuit command:
- if the measured rotational speed (Ω) is less than a second safety speed, and
- if the time variation (dV*) of the measured voltage (V) of the direct voltage source (B) is less than a second safety variation.

4. Control system (2) according to claim 1, **characterised in that** the first safety speed is the speed at which an electromotive force of the rotating electrical machine is less than a given voltage, for example 48V.

5. Control system (2) according to one of the preceding claims, **characterised in that** the first safety variation is negative, in particular less than -0.2 V/µs.

6. Control system (2) according to any one of the preceding claims, **characterised in that** the first group of switches is the low group.

7. Control system (2) according to any one of the preceding claims, **characterised in that** the voltage (V) measured by the first measurement module is the voltage between two terminals (B+, B-) of the voltage converter (0) configured to be connected to the direct voltage source (B).

8. Electrical system (SE) comprising:
- a first (B+) and a second (B-) supply terminals configured to be connected to the direct voltage source (B), in particular to a battery of a motor vehicle;
- the rotating electrical machine (M) comprising a stator having at least three phases (U, V, W);
- the voltage converter (0), each midpoint (PX, PY, PZ) of the voltage converter (0) being connected to at least one of the phases (U, V, W) of said rotating electrical machine (M) and a control unit (1) of the high-side and low-side switches, said control unit (1) comprising the control system (2) according to any one of the preceding claims.

9. Electrical system (SE) according to claim 8, **characterised in that** the control unit (1) further comprises:
- a controller (5) configured to control the high-side and low-side switches,
- a machine control module (3) configured to receive from an electronic control unit of the vehicle a setpoint for either placing the rotating electrical machine (M) in motor mode or placing the rotating electrical machine (M) in alternator mode, and arranged to transform this setpoint into a command for controlling the high-side and low-side switches of the voltage converter (0),
- a logic module (4) for prioritising the commands issued by the control system (2) over the commands issued by the machine control module (3), the logic module (4) transmitting to the controller (5) the switch command received either from the machine control module (3) or from the control system (2).

10. Mobility vehicle **characterised in that** it comprises an electrical system (SE) according to any one of claims 8 to 9.
